Europäisches Patentamt

European Patent Office

Office européen des brevets

(19)

(11) Numéro de publication: **0 011 533**
**B1**

(12) **FASCICULE DE BREVET EUROPEEN**

(45) Date de publication du fascicule du brevet: **24.03.82**

(51) Int. Cl.³: **H 03 K 4/56**, H 04 N 3/16

(21) Numéro de dépôt: **79400788.0**

(22) Date de dépôt: **23.10.79**

(54) Circuit générateur de dents de scie permettant notamment un balayage cathodique du type ligne par ligne, et dispositif comportant un tel circuit.

(30) Priorité: **14.11.78 FR 7832107**

(43) Date de publication de la demande:
**28.05.80 Bulletin 80/11**

(45) Mention de la délivrance du brevet:
**24.03.82 Bulletin 82/12**

(84) Etats contractants désignés:
**DE GB IT NL**

(56) Documents cités:
**FR - A - 2 144 275**

**Electronic Engineering, vol. 44, no. 538, décembre 1972, Londres, GB, J. Tribolet: "Original sawtooth generator" page 40**

**Electronics, vol. 46, no. 2, 18 janvier 1973, New York, US, D. M. Brockman: "Synchronous ramp generator maintains output linearity", page 170**

**Electronics Letters, vol. 13, no. 13, 23 juin 1977, Londres, GB, Carter et al.: "Accurate broad-band square-to-triangle convertor" pages 381, 382**

(73) Titulaire: **THOMSON-CSF**
**173, Boulevard Haussmann**
**F-75360 Paris Cedex 08 (FR)**

(72) Inventeur: **Heuze, Philippe**
**"THOMSON-CSF" - SCPI 173, bld Haussmann**
**F-75360 Paris Cedex 08 (FR)**
Inventeur: **Lambert, Pierre**
**"THOMSON-CSF" - SCPI 173, bld Haussmann**
**F-75360 Paris Cedex 08 (FR)**

(74) Mandataire: **Trocellier, Roger et al,**
**"THOMSON-CSF" - SCPI 173, bld Haussmann**
**F-75360 Paris Cedex 08 (FR)**

Courier Press, Leamington Spa, England.

# Circuit générateur de dents de scie permettant notamment un balayage cathodique du type ligne par ligne, et dispositif comportant un tel circuit

La présente invention concerne un circuit générateur de dents de scie permettant notamment un balayage cathodique du type ligne par ligne. L'invention s'applique en particulier à réaliser les circuits de balayage ligne et trame d'une caméra de prise de vues de télévision, monochrome ou trichrome.

Un montage intégrateur de base comporte un amplificateur opérationnel avec une capacité connectée comme impédance de contre-réaction entre la sortie et une entrée recevant une tension continue constante à travers une résistance. Pour produire des dents de scie, il suffit de décharger périodiquement le condensateur par la commande d'une impulsion périodique appliquée sur un interrupteur, par exemple un circuit porte analogique tel un transistor à effet de champ, connecté aux bornes de la capacité.

La stabilité de ces montages générateurs de dents de scie de balayage est sujette à caution lorsque la température varie. Pour améliorer la stabilisation de l'amplitude des signaux en dents de scie, il peut être fait appel à des composants passifs ayant un très faible coefficient de température. Ces composants sont chers et encombrants, et leur action reste assez limitée.

Il est connu pour améliorer la stabilisation d'utiliser une boucle entre la sortie du montage et l'entrée de l'amplificateur où se trouve connectée la capacité d'intégration. L'alimentation continue en ce point est alors remplacée par la sortie de boucle. Celle-ci comporte généralement un circuit intégrateur de la valeur moyenne présentée par la dent de scie. Les montages à boucle existent sous diverses formes, l'une d'elles décrite dans "ELECTRONIC LETTERS", vol. 13 no. 13 du 23 juin 1977, article de CARTER et al., intitulé "Accurate broadband square-to-triangle convertor", pages 381—382, utilise une source de courant en sortie de boucle. Ces montages ne permettent guère de faire varier de manière rapide l'amplitude de la dent de scie pour des besoins d'exploitation, à cause de la constante de temps de la boucle.

L'objet de l'invention est de réaliser un circuit générateur de dents de scie remédiant à ces inconvénients et présentant une haute stabilité, celle-ci pouvant notamment dépasser aisément un pour mille lorsque la température effectue une excursion de 50°C dans la plage —55°C à +125°C. En outre, le circuit générateur selon l'invention présente l'avantage d'une adaptation rapide à des changements d'amplitude ou de fréquence pour le signal en dents de scie, ce qui présente un grand intérêt pour l'application à des caméras de télévision multi-standards et multi-formats.

Suivant la présente invention on réalise un circuit générateur de dents de scie permettant notamment un balayage cathodique du type ligne par ligne et comportant: un amplificateur opérationnel avec une sortie et deux entrées, monté en intégrateur avec une capacité connectée entre la sortie et une première entrée, des moyens d'alimentation continue pour produire au moins deux tensions continues destinées à l'intégrateur, l'une des tensions étant appliquée à la deuxième entrée de l'amplificateur, un premier circuit interrupteur connecté aux bornes de la capacité et commandé périodiquement à la fermeture par un train d'impulsions produit par un générateur d'impulsions annexe, un deuxième circuit interrupteur connecté par une extrémité en sortie de l'amplificateur, et une boucle d'asservissement comportant un circuit filtre passe-bas pour produire une tension correspondant à la valeur moyenne de la dent de scie, et étant caractérisé en ce que lesdites tensions continues comportent une première tension appliquée à travers une première résistance sur la première entrée de l'amplificateur, et une seconde tension de même polarité mais de valeur inférieure à la première tension et qui constitue la tension appliquée à la deuxième entrée, la boucle d'asservissement étant connectée entre la sortie de l'amplificateur qui délivre les signaux en dents de scie vers l'exploitation et la première entrée de l'amplificateur, cette dernière connexion s'effectuant à travers une deuxième résistance, ladite boucle incluant le deuxième circuit interrupter connecté en série par son autre extrémité avec le circuit filtre passe-bas et commandé par le générateur d'impulsions en opposition de phase par rapport au premier circuit interrupter.

Les particularités et avantages de l'invention apparaîtront au cours de la description qui suit donnée à titre d'exemple non limitatif à l-aide des figures annexées qui représentent:

— la figure 1, un schéma d'un circuit générateur de dents de scie conforme à l'invention;
— la figure 2, des formes d'ondes relatives au fontionnement du circuit selon la figure 1; et
— la figure 3, un exemple de réalisation du circuit selon la figure 1 dans une application à un standard de balayage ligne d'une caméra deprise de vue.

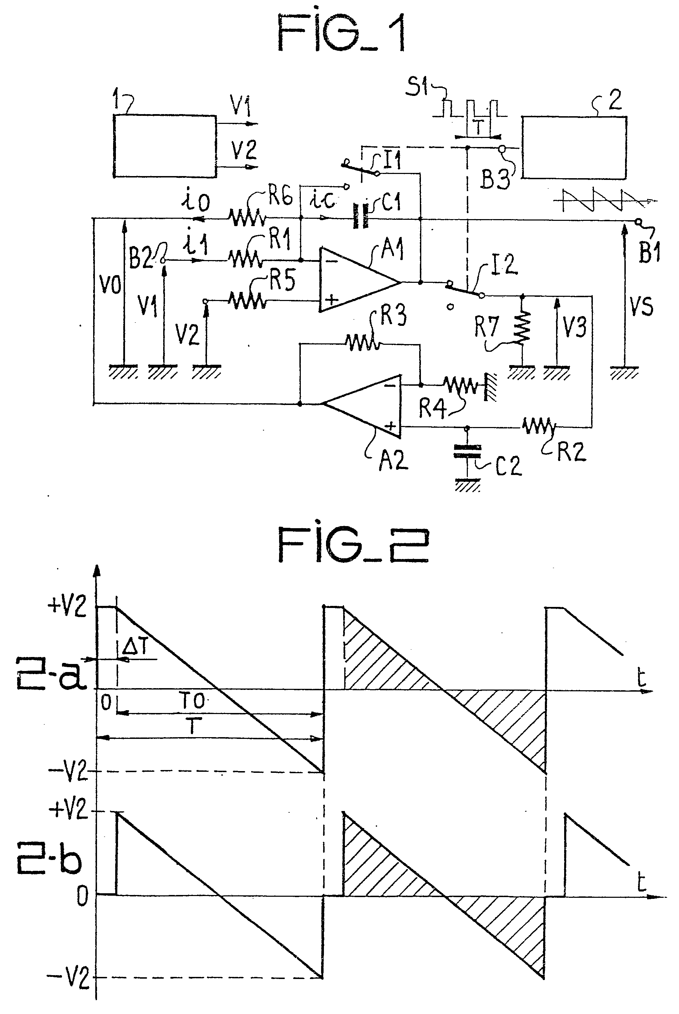

En se reportant à la figure 1, les éléments formant un circuit intégrateur conventionnel sont constitués par l'amplificateur opérationnel A1, la capacité C1 et la résistance R1. En appliquant une tension continue V1 à l'extrémité libre de la résistance on obtient une tension de sortie

$$VS = \frac{1}{R1C1} \int V1 \, dt.$$

La tension V1 étant une tension constante fournie par une alimentation continue annexe 1 à très haute stabilité, le signal VS résultant de l'intégration varie linéairement avec le temps t. Pour produire des dents de scie de balayage, ce circuit de base est complété par un interrupteur analogique I1 commandé périodiquement à la fermeture à la cadence désirée. Le bloc 2 symbolise un circuit annexe de commande périodique de l'interrupteur I1, tel qu'un circuit de synchronisation ligne ou trame, délivrant un train d'impulsion S1 à la période de répétition T envisagée.

Ce montage est aménagé conformément à la présente invention pour assurer dans le temps une grande stabilité de l'amplitude des dents de scie en cas de variation de la température ambiante.

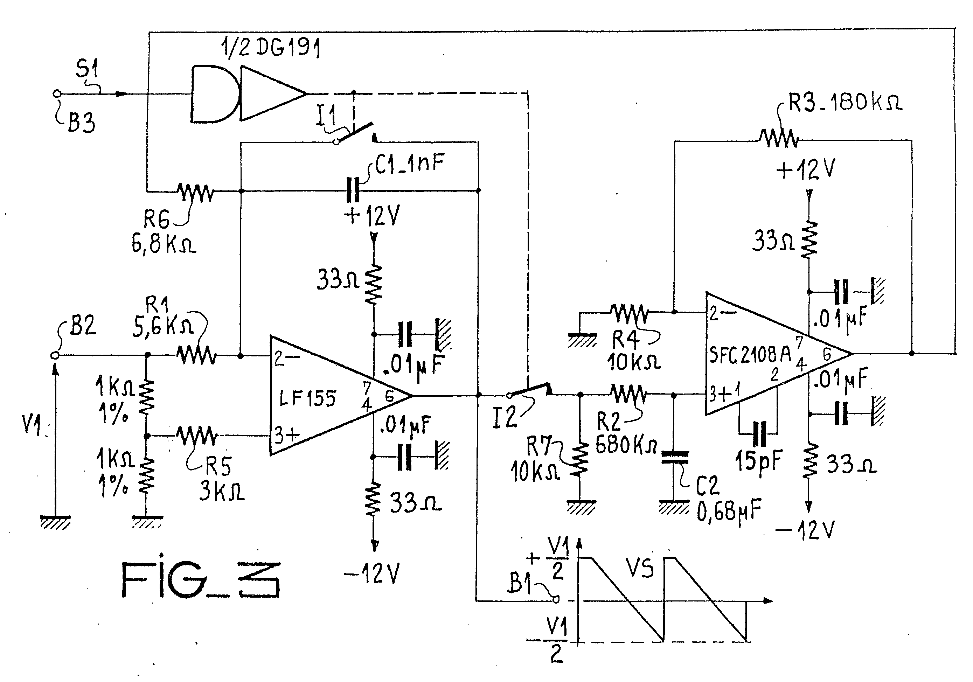

Les aménagements portent à titre principal sur la réalisation d'une boucle d'asservissement de la valeur moyenne de la dent de scie. A cet effet la boucle comporte un circuit filtre passe-bas présentant une fréquence de coupure très basse, par exemple inférieure à 10Hz, pour filtrer pratiquement le continu à la fréquence zéro. Le circuit filtre passe-bas peut consister en une cellule RC représentée par les éléments R2 et C2 et suivie par un amplificateur pour conférer à la boucle un gain déterminée; l'amplificateur comporte un amplificateur opérationnel A2 et les éléments résistifs R3 et R4. En outre il est produit une seconde tension continue stabilisée V2 de valeur inférieure à celle de la tension V1 et qui est appliquée sur l'entrée non inverseuse, ou entrée positive, de l'amplificateur A1 à travers une résistance R5. Le circuit de boucle produit une tension VO ramenée sur l'entrée négative de l'amplificateur A1 à travers une resistance R6. La boucle permet de compenser le faibles variations d'amplitude du signal de sortie VS, dues essentiellement à des dérives en température de la capacité C1, de la résistance R1 et de l'offset de l'amplificateur A1. Le montage produit une dent de scie VS variant entre le potentiel initial +V2 et un potentiel inférieur en cours de chaque période de fonctionnement. De manière préférentielle, le montage est déterminé en sorte que la dent de scie est symétrique par rapport au potentiel zéro de référence, variant de +V2 à —V2 (figure 2-a), pour une température ambiante correspondant sensiblement à la température moyenne dans la plage de variation thermique envisagée. Dans ces conditions le fonctionnement de la boucle est le plus intéressant car la tension d'erreur VO ramenée à l'entrée reste d'amplitude très faible, égale à zéro après action de la boucle qui ne nécessite pas de présenter un gain élevé. On verra ultérieurement que ces conditions préférentielles de fonctionnement résultent principalement du choix du rapport

$$\frac{V1}{V2},$$

des valeurs des éléments R1, R6 et C1 et de la durée de la dent de scie.

Un autre aménagement du circuit générateur de dents de scie consiste à introduire à l'entrée de la boucle un circuit interrupteur analogique I2 analogue à l'interrupteur I1 et commandé en opposition avec ce dernier. Ainsi le temps de réinitialisation, temps bref ΔT, pendant lequel I1 reste fermé et où le signal de sortie VS passe quasi instantanément de —V2 à +V2 puis reste à cette valeur jusqu'à réouverture de l'interrupteur I1 (figure 2-a), n'est pas pris en compte pour la mesure de la valeur moyenne de la dent de scie; le signal pris en compte correspond à la partie utile de la dent de scie de durée TO, représentée par les zones hachurées.

La résistance R7 connectée entre la sortie de l'interrupteur I2 et la masse a pour rôle de remédier aux parasites de commutation de l'interrupteur analogique I2. La figure 2b représente le signal V3 à l'entrée de la boucle.

Le fonctionnement du circuit générateur de dents de scie selon l'invention est le suivant: lorsque l'interrupteur I1 est commandé à la fermeture, le condensateur C1 se décharge instantanément ramenant la tension de sortie VS à la valeur +V2 de référence. Lorsque l'interrupteur I1 est à nouveau ouvert le condensateur C1 se charge à courant constant ic selon la relation $ic = i_1 - i_0$, $i_1$ étant le courant circulant dans la résistance R1 et $i_0$ celui circulant dans la résistance R6 comme indiqué sur la figure 1. Les valeurs $i_1$ et $i_0$ sont données par les relations

$$i_1 = \frac{V1 - V2}{R1} \quad \text{et}$$

$$i_0 = \frac{V2 - VO}{R6}.$$

D'autre part

$$VS = V2 - \frac{ic}{C1} t$$

et si l'on suppose VO=0 en régime établi, en remplaçant ic par valeur on obtient

$$VS = V2\left(1 + \frac{t}{R1C1} + \frac{t}{R6C1}\right) - \frac{V1}{R1C1} t$$

Pour obtenir VS=—V2 à t=TO on en déduit la relation:

$$V1 = \left(\frac{2R1C1}{TO} + 1 + \frac{R1}{R6}\right)V2,$$

$$\text{où } TO = \frac{2R1C1}{\frac{V1}{V2} - 1 - \frac{R1}{R6}}$$

donc V1 supérieur à V2.

A titre d'exemple, si l'on se fixe le rapport

$$\frac{V1}{V2}$$

égal à 2 on obtient,

$$TO = 2 \cdot \frac{R1R6}{R6-R1} \cdot C1$$

qui implique R6 supérieur à R1. La durée TO est une constante imposée dans le cas d'un balayage ligne ou trame et les éléments R1, R6 et C1 seront déterminés pour satisfaire à la relation.

L'expression complète du courant de charge est donnée par

$$ic = \frac{V1-V2}{R1} - \frac{V2-VO}{R6}$$

qui montre que ce courant dépend de VO et met en évidence l'action de la boucle qui ramène la valeur moyenne VO à l'entrée de l'intégrateur, cette valeur devenant nulle lorsque la dent de scie est parfaitement symétrique. Si la courbe est dissymétrique, par exemple vers les potentiels positifs, une tension d'erreur +VO apparaît, le courant $i_o$ diminue et celui de charge $i_c$ augmente; la capacité C1 se charge donc plus rapidement et le signal VS est ramené progressivement vers les potentiels négatifs jusqu'à annulation de l'erreur.

Dans la pratique, la tension V2 sera avantageusement obtenue à partir de la tension V1 au moyen d'un pont diviseur à résistances fixes de haute stabilité, la tension unique V1 étant elle même produite par une source continue de haute stabilité. Cette solution permet entre autre de modifier l'amplitude de la dent de scie sans affecter le fonctionnement de la boucle, par simple modification du paramètre V1. La dent de scie tourne alors autour de son point médian (point d'amplitude zéro figure 2-a), la pente étant modifiée. Ceci peut être appliqué notamment pour modifier le format d'analyse d'une caméra de prise de vue, ou pour effectuer un zoom électronique au niveau du tube de la caméra par sous-balayage.

Dans le cas d'un changement de fréquence et que l'on s'éloigne de la valeur envisagée

$$F = \frac{1}{T}$$

pour cadencer la fermeture de l'interrupteur I1, il apparaît un signal d'erreur VO qui entraîne une correction par le courant de charge ic.

En posant

$$F1 = \frac{1}{T1}$$

et T1=T+ΔTO, et pour l'exemple considéré ou V1=2V2, le calcul de VO donne: donne:

$$VO = \frac{R6-R1}{R1} \cdot \frac{\Delta TO}{T1} \cdot V2$$

ou, VO=−2R6C1.ΔF.V2 avec ΔF=F−F1. Ce résultat confirme le fonctionnement de la boucle pour maintenir la valeur moyenne au potentiel moyen nul lorsque F varie. Il est ainsi possible de modifier la récurrence T des signaux de synchronisation S1. Toutefois, le gain de boucle limite en fait la variation maximale admissible pour l'excursion de fréquence. Une excursion importante est possible tout en préservant la stabilité de la boucle, en modifiant par exemple la valeur du composant passif R6, ce qui peut être obtenu par commutation de résistance, l'élément résistif R6 étant remplacé par un autre élément résistif de valeur différente prévu à cet effet. Le montage selon l'invention autorise le fonctionnement à la fréquence ligne d'une caméra répondant aux standards 525 lignes 60 Hz et 625 lignes 50 Hz sans changement de composants passifs; seule la période de synchronisation S1 est à modifier, L'extension au standard 875 lignes 60 Hz est envisageable en prévoyant, de préférence, le changement de valeur de la résistance R6.

La figure 3 donne un exemple de réalisation du circuit générateur de dents de scie. La tension V2 est obtenue par un pont diviseur à résistances à partir d'une tension stabilisée V1 de 4 volts appliquée entre la borne B2 et masse. Le circuit filtre passe-bas R2C2 présente une fréquence de coupure de 2,4 Hz et une atténuation théorique de 77 dB pour la fréquence 15,6 KHz prévue pour la dent de scie (standard télévision 625 lignes 50 Hz). Le signal VS est prélevé sur la borne de sortie B1 pour être appliqué ensuite à des circuits d'exploitation en aval par exemple, les circuits de déflexion horizontale d'un tube, tel un vidicon dans le cas d'une caméra de prise de vue. Les composants R6, R1 et C1 sont déterminés en fonction du standard prévu, le circuit générateur étant plus particulièrement destiné à opérer sur tous standards de balayage ligne, pour des périodes allant notamment de 64 μs (standard 625 lignes 50 Hz) à 38,1 μs (standard 875 lignes 60 Hz). Le circuit référencé 1/2 DG 191 inclut les interrupteurs I1, I2. Le circuit générateur peut être utilisé tout aussi bien pour élaborer des signaux en dents de scie répondant au balayage de trame, soit pour des périodes allant de 16,6 à 20 ms pour les fréquences des standards considérées, ou pour toute autre application nécessitant des signaux de la forme considérée avec des caractéristiques de très haute stabilité.

## Revendications

1. Circuit générateur de dents de scie permettant notamment un balayage cathodique du type ligne par ligne et comportant: un amplificateur opérationnel (A1) avec une sortie et deux entrées, monté en eintégrateur avec une capacité connectée entre la sortie et une première entrée, des moyens d'alimentation continue pour produire au moins deux tensions continues destinées à l'intégrateur, l'une des tensions (V2) étant appliquée à la deuxième entrée de l'amplificateur, un premier circuit interrupteur (I1) connecté aux bornes de la capacité et commandé périodiquement à la fermeture par un train d'impulsions (S1) produit par un générateur d'impulsions (2) annexe, un deuxième circuit interrupteur (I2) connecté par une extrémité en sortie de l'amplificateur, et une boucle d'asservissement comportant un circuit filtre passe-bas (R2—C2) pour produire une tension (VO) correspondant à la valeur moyenne de la dent de scie, et étant caractérisé en ce que lesdites tensions continues comportent une première tension (V1) appliquée à travers une première résistance (R1) sur la première entrée de l'amplificateur, et une seconde tension (V2) de même polarité mais de valeur inférieure à la première tension et qui constitue la tension appliquée à la deuxième entrée, la boucle d'asservissement étant connectée entre la sortie de l'amplificateur qui délivre les signaux en dents de scie (VS) vers l'exploitation et la première entrée de l'amplificateur, cette dernière connexion s'effectuant à travers une deuxième résistance (R6), ladite boucle incluant le deuxième circuit interrupteur connecté en série par son autre extrémité avec le circuit filtre passe-bas et commandé par le générateur d'impulsions en opposition de phase par rapport au premier circuit interrupteur.

2. Circuit selon la revendication 1, caractérisé en ce que le circuit filtre passe-bas est constitué par une cellule RC (R2, C2) de fréquence de coupure quelques Hertz suivi d'un amplificateur réalisé en montage amplificateur opérationnel (A2, R3, R4), la sortie de l'amplificateur de boucle étant connecté à ladite deuxième résistance (R6).

3. Circuit selon l'une quelconque des revendications précédentes, caractérisé en ce que les valeurs des deux tensions continues (V1, V2) et celles des première et deuxième résistances et de la capacité sont déterminées en sorte que la dent de scie est symétrique de part et d'autre du potentiel zéro de référence et la tension (VO) produite par la boucle traduit les dérives de la valeur moyenne par rapport à ce potentiel nul.

4. Circuit selon la revendication 3, caractérisé en ce que la première tension (V1) est de valeur double de la deuxième tension (V2) et la durée (TO) de la dent de scie est donnée par la relation

$$\left(2 \cdot \frac{R6R1}{R6-R1} \cdot C\right)$$

où C est la capacité d'intégration, R1 la première résistance et R6 la deuxième résistance.

5. Circuit selon l'une quelconque des revendications précédentes, caractérisé en ce que la seconde tension continue (V2) est produite à partir de la première tension (V1) au moyen d'un diviseur résistif, une alimentation continue (1) annexe délivrant la première tension continue, le générateur d'impulsions (2) délivrant des impulsions de synchronisation ligne ou trame d'un balayage de télévision du type ligne par ligne et la dent de scie produite étant exploitée pour produire le balayage horizontal ou vertical correspondant d'une caméra de prise de vue.

6. Circuit selon la revendication 5, caractérisé en ce que des moyens de réglage de l'amplitude de la première tension sont prévus pour faire varier l'amplitude des dents de scie.

7. Circuit selon l'une quelconque des revendications précédentes, caractérisé en ce que des moyens de réglage de la récurrence (T) des impulsions de synchronisation sont prévus pour faire varier la période des dents de scie.

8. Dispositif, notamment caméra de prise de vue, utilisant un circuit générateur de dents de scie selon l'une quelconque des revendications précédentes.

**Patentansprüche**

1. Sägezahngeneratorschaltung, die insbesondere eine zeilenweise Katodenstrahlablenkung gestattet und enthält: einen Operationsverstärker (A1) mit einem Ausgang und zwei Eingängen, und welche als Integrator mit einer zwischen den Ausgang und einen ersten Eingang gelegten Kapazität geschaltet ist, Gleichspannungsversorgungsmittel zur Erzeugung von wenigstens zwei Gleichspannungen, die für den Integrator bestimmt sind, wobei die eine der Spannungen (V2) an den zweiten Eingang des Verstärkers angelegt wird, eine erste Unterbrecherschaltung (E1), die an die Anschlüsse der Kapazität angelegt ist und periodisch in den Schließzustand gesteuert wird durch eine Impulsfolge (S1), die von einem beigeordneten Impulsegenerator (2) erzeugt wird, eine zweite Unterbrecherschaltung (I2), die mit einem Ende an den Ausgang des Verstärkers angelegt ist, und eine Regelschleife mit einer Tiefpaß-Filterschaltung (R2—C2) zur Erzeugung einer Spannung (VO), die dem Mittelwert des Sägezahns entspricht, und dadurch gekennzeichnet, daß die kombinierten Spannungen eine erste Spannung (V1), die über einen ersten Widerstand (R1) an den ersten Eingang des Verstärkers angelegt wird, und eine zweite Spannung (V2) umfaßt, welche dieselbe Polarität aufweist wie die erste Spannung und welche die an den zweiten Eingang angelegte Spannung ist, wobei die Regelschleife zwischen den Ausgang des Verstärkers, der die Sägezahnsignale (VS) an den Verbraucher liefert, und den ersten Eingang des Verstärkers geschaltet ist, und zwar über einen zweiten Widerstand (R6), und wobei die Schleife die zweite Unterbrecherschaltung enthält, die an ihrem anderen Ende in Reihe mit der Tiefpaß-Filter-schaltung angeordnet ist und von dem Impulsgenerator mit entgegengesetzter Phase wie die erste Unterbrecherschaltung angesteuert wird.

2. Schaltung nach Anspruch 1, dadurch gekennzeichnet, daß die Tiefpaß-Filterschaltung aus einem RC-Glied (R2, C2) mit einer Grenzfrequenz von einigen Hertz gebildet ist, gefolgt von einem als Operationsverstärkerschaltung (A2, R3, R4) angeordneten Verstärker, wobei der Ausgang des Schleifenverstärkers an den zweiten Widerstand (R6) angeschlossen ist.

3. Schaltung nach einem der vorstehenden Ansprüche, dadurch gekennzeichnet, daß die Werte der beiden Gleichspannungen (V1, V2) und die Werte des ersten und des zweiten Widerstandes sowie der Kapazität so bestimmt sind, daß der Sägezahn auf beiden Seiten des Bezugs-Nullpotentials symmetrisch ist und die von der Schleife erzeugte Spannung (VO) die Abweichungen des Mittelwertes in bezug auf dieses Nullpotential wiedergibt.

4. Schaltung nach Anspruch 3, dadurch gekennzeichnet, daß die erste Spannung (V1) den doppelten Wert wie die zweite Spannung (V2) hat und die Dauer (TO) des Sägezahns gegeben ist durch die Bezeihung

$$(2 \cdot \frac{R6R1}{R6-R1} \cdot C),$$

worin C die Integrierkapazität, R1 der erste Widerstand und R6 der zweite Widerstand sind.

5. Schaltung nach einem der vorstehenden Ansprüche, dadurch gekennzeichnet, daß die zweite Gleichspannung (V2) aus der ersten Spannung (V1) mittels eines resistiven Spannungsteilers gebildet wird, wobei eine Gleichspannungs-Hilfsversorgungsquelle (1) die erste Gleichspannung liefert, während der Impulsgenerator (2) Zeilen- oder Bild-Synchronisationsimpule einer zeilenweiser Ablenkung arbeitenden Fernsehablenkung liefert und der erzeugte Sägezahn verwendet wird, um die entsprechende Horizontaloder Vertikalablenkung einer Aufnahmekamera zu bewirken.

6. Schaltung nach Anspruch 5, dadurch gekennzeichnet, daß Mittel zum Einstellen der Amplitude der ersten Spannung vorgesehen sind, um die Amplitude der Sägezähne zu verändern.

7. Schaltung nach einem der vorstehenden Ansprüche, dadurch gekennzeichnet, daß Mittel zum Einstellen der Wiederholungsfrequenz (T) der Synchronisationsimpulse vorgesehen sind, um die Periode der Sägezähne zu verändern.

8. Vorrichtung, insbesondere Aufnahmekamera, bei der ein Sägezahngenerator nach einem der vorstehenden Ansprüche verwendet wird.

**Claims**

1. Saw tooth generator circuit, particularly one allowing line by line cathode ray scanning and comprising: an operational amplifier (A1) having one output and two inputs, and mounted as an integrator having a capacity connected between the output and a first input, direct supply means for providing at least two direct voltages for the integrator, one of the voltages (V2) being applied to the second input of the amplifier, a first interrupter circuit (E1) connected to the terminals of the capacity and periodically controlled into the closed state by a pulse series (S1) produced by an associated pulse generator (2), a second interrupter circuit (I2) connected at one end to the output of the amplifier, and a control loop comprising a low-pass filter circuit (R2—C2) for producing a voltage (VO) corresponding to the average value of the saw tooth, and being characterized in that said combined voltages comprise a first voltage (V1) applied to the first input of the amplifier through a first resistor (R1) and a second voltage (V2) of the same polarity as but of lower value than the first voltage and being the voltage applied to the second input, the control loop being connected between the output of the amplifier delivering the saw tooth signals (VS) towards the user and the first input of the amplifier, the latter connection being made through a second resistor (R6), said loop including the second interrupter circuit series connected with the low-pass filter circuit on its other end and controlled by the pulse generator in opposed phase relationship with respect to the first interrupter circuit.

2. Circuit in accordance with claim 1, characterized in that the low-pass filter circuit is made by an RC member (R2, C2) having a cutoff frequency of several hertz followed by an amplifier formed as an operational amplifier circuit (A2, R3, R4), the output of the loop amplifier being connected to the second resistor (R6).

3. Circuit in accordance with any of the preceding claims, characterized in that the values of the two direct voltages (V1, V2) and those of the first and second resistor and of the capacity are determined in such a manner that the saw tooth is symmetrical on both sides of the reference zero potential, and the voltage (VO) produced by the loop reproduces deviations of the average value with respect to this zero potential.

4. Circuit in accordance with claim 3, characterized in that the first voltage (V1) has twice the value of the second voltage (V2) and that the duration (TO) of the saw tooth is given by the relation

$$(2 \cdot \frac{R6R1}{R6-R1} \cdot C),$$

wherein C is the integrator capacity, R1 the first resistor and R6 the second resistor.

5. Circuit in accordance with any of the preceding claims, characterized in that the second direct voltage (V2) is produced from the first voltage (V1) using a resistive divider, an associated direct supply (1) providing the first direct voltage, the pulse generator (2) providing the line or frame synchronizing pulses of a line by line television scanning system, and the saw tooth produced being used to provide corresponding horizontal or vertical scanning of an image camera.

6. Circuit in accordance with claim 5, characterized in that means for adjusting the amplitude of the first voltage are provided to vary the amplitude of the saw tooth signal.

7. Circuit in accordance with any of the preceding claims, characterized in that means for adjusting the recurrence (T) of the synchronizing pulses are provided to vary the periods of the saw tooth signal.

8. Device, particularly an image camera, using a saw tooth generator circuit in accordance with any of the preceding claims.

# FIG_1

# FIG_2

FIG_3